# FASCICULE DE BREVET EUROPEEN

(11) **EP 3 864 390 B1**
(45) Date de publication et mention de la délivrance du brevet: **24.06.2026**
(21) Numéro de dépôt: 19780280.4
(22) Date de dépôt: 09.10.2019
(51) Int. Cl.: G01L 19/00, B81B 7/00, B81C 3/00, G01L 19/04, H05K 1/02, H05K 3/341, H10W 40/22, H10W 40/40

(54) **ASSEMBLAGE ELECTRONIQUE ET DISPOSITIF DE MESURE DE PRESSION A DURABILITE AMELIOREE**
ELEKTRONISCHE BAUGRUPPE UND DRUCKMESSVORRICHTUNG MIT VERBESSERTER BESTÄNDIGKEIT
ELECTRONIC ASSEMBLY AND PRESSURE MEASUREMENT DEVICE WITH IMPROVED DURABILITY

(30) Priorité: 11.10.2018 FR 1859426
(43) Date de publication de la demande: 18.08.2021
(73) Titulaire: Safran Electronics & Defense, 75015 Paris (FR)
(72) Inventeur: RIOU, Jean-Christophe, 92100 Boulogne-Billancourt (FR); SRIDI-CONVERS, Nawres, 92100 Boulogne-Billancourt (FR); BAILLY, Eric, 92100 Boulogne-Billancourt (FR)
(74) Mandataire: Cabinet Boettcher
(86) Numéro de dépôt international: PCT/EP2019/077425
(87) Numéro de publication internationale: WO 2020/074616

(56) Documents cités:
- EP-A1- 1 667 508
- US-A1- 2006 196 408
- US-A1- 2007 013 014

## Description

### DOMAINE DE L'INVENTION

La présente invention concerne le domaine des assemblages électroniques et plus particulièrement le domaine des capteurs électromécaniques de pression de fluide pour des applications aéronautiques.

### ARRIERE PLAN DE L'INVENTION

Un assemblage électronique comprend classiquement un substrat sur lequel est rapporté un composant électronique à l'aide d'un joint fritté ou brasé. L'assemblage permet une jonction mécanique et électrique du composant électronique et du substrat. En fonctionnement, l'assemblage est soumis à des cycles thermiques et les dilatations différentielles du substrat et du composant fon travailler le joint et le composant électronique ce qui peut affecter sa précision de mesure et sa durabilité.

L'utilisation d'un joint de colle souple conductrice permet de découpler mécaniquement le substrat et le composant et de réduire l'effet des dilatations différentielles sur la précision du capteur et sa tenue dans le temps. Cependant, si les performances mécaniques sont bonnes, on observe une migration des paillettes métalliques conductrices du joint de colle et une augmentation importante de sa résistance électrique avec le temps.

Ainsi, les assemblages électroniques existants ne permettent pas de garantir une jonction mécanique et électrique durable du composant et du substrat tout en établissant un niveau de découplage thermomécanique adapté à la taille et la sensibilité du composant et les dispositifs de mesure

Les documents US2006/0196408 et US2007/0013014 décrivent des exemples de tels assemblages électroniques. Le document EP1667508 décrit quant à lui un procédé d'assemblage de composants.

### OBJET DE L'INVENTION

L'invention a pour objet d'améliorer la résistance en fatigue d'un assemblage électronique aux sollicitations thermomécaniques.

### RESUME DE L'INVENTION

A cet effet, on prévoit un dispositif comprenant un assemblage électronique comportant un composant électronique assemblé sur un premier substrat et un corps définissant une cavité dont une première extrémité est en lien fluidique avec un fluide, le composant électronique s'étendant dans la cavité et le premier substrat comprenant une portion en contact avec une paroi de la cavité. Avantageusement le coefficient de dilatation thermique du matériau du premier substrat est inférieur à celui du composant électronique, et le composant électronique est assemblé par une méthode d'assemblage avec apport de chaleur de type brasage sur le premier substrat. Un tel dispositif permet d'atténuer les vibrations et les efforts thermomécaniques transmis depuis le milieu environnant jusqu'au composant électronique. La fixation de l'assemblage sur le dispositif est également simplifiée par un tel montage.

Le dispositif de l'invention est particulièrement adapté à la mesure de la pression lorsque le composant électronique est un capteur de pression.

Les vibrations et les efforts thermomécaniques sont encore plus fortement atténués lorsque le substrat est un substrat flexible.

L'ampleur des mouvements du premier substrat est efficacement limitée lorsque la portion en contact avec une paroi de la cavité est une portion courbée.

L'atténuation des vibrations et des efforts thermomécaniques transmis depuis le milieu environnant jusqu'au composant électronique est améliorée lorsque le premier substrat exerce un effort élastique la paroi de la cavité.

Les transitoires de pression et les microparticules sont efficacement filtrés lorsque le premier substrat comprend des orifices destinés à laisser passer une fraction du fluide dont la pression est à mesurer.

La construction du dispositif est facilitée lorsque le premier substrat est relié à un deuxième substrat qui porte une unité de communication et un port de communication.

Avantageusement, le deuxième substrat est un substrat rigide ou un substrat flexible.

Avantageusement encore, le deuxième substrat s'étend en partie dans la cavité
Le filtrage du fluide à mesurer est amélioré lorsque le dispositif comprend une grille s'étendant devant la première extrémité de la cavité.

La construction du dispositif est également économique lorsque la cavité est définie au moins partiellement par une chemise en métal, préférentiellement en acier inoxydable.

La construction du dispositif est économique lorsque le corps est en matériau thermoplastique.

L'invention concerne également un procédé de réalisation d'un assemblage électronique comprenant les étapes de, lors d'une phase préparatoire, sélectionner un composant électronique et sélectionner un premier substrat sur lequel doit être assemblé le composant électronique de manière à ce que le coefficient de dilatation thermique du matériau du substrat soit inférieur à celui du composant électronique. Le procédé comprend également, lors d'une phase d'assemblage, l'étape d'assembler, par une méthode d'assemblage avec apport de chaleur de type brasage, le composant électronique et le substrat.

Le différentiel de coefficient de dilatation thermique entre le composant et le premier substrat provoque, à l'issue de l'opération d'assemblage, une rétraction différentielle du composant et du premier substrat qui vient mettre en précontrainte le premier substrat. Lorsque l'assemblage est soumis à des cycles de température, l'effort maximal auquel sont soumis les points de liaison entre le substrat et le composant est diminué de la valeur de la précontrainte ce qui permet d'améliorer la tenue en fatigue de l'assemblage de l'invention.

La robustesse de l'assemblage est améliorée lorsque la phase préparatoire comprend l'étape supplémentaire de sélectionner un premier substrat et un composant dont les matériaux ont tous deux une température de transition vitreuse ou une température de fusion supérieure à une température de service de l'assemblage électronique.

La tenue en fatigue est encore améliorée lorsque la phase préparatoire comprend l'étape supplémentaire de sélectionner un premier substrat et un composant électronique ainsi qu'une technique d'assemblage qui aboutissent à une contrainte après assemblage dans les points de jonction entre le substrat et le composant inférieur à 0.1?N/mm²

Une réalisation fiable et économique de l'assemblage électronique est possible lorsque la méthode d'assemblage avec apport de chaleur est du brasage ou du frittage ou du frittage d'argent ou comprend la réalisation de connections par billes d'or.

L'invention concerne également un assemblage électronique obtenu par le procédé ci-dessus.

L'assemblage peut être aisément intégré à un dispositif compact lorsque le premier substrat sélectionné est un substrat flexible.

Les opérations de liaison entre le substrat et le composant sont facilitées lorsque le premier substrat est un substrat texturé.

La tenue en fatigue est améliorée lorsque le premier substrat est un substrat à base de polymères à cristaux liquides.

La réalisation de l'assemblage est facilitée lorsque l'assemblage comprend un composant assemblé en puce retournée.

La compacité de l'assemblage est améliorée lorsque l'assemblage comprend au moins un composant comportant un empilement de puces.

L'assemblage est efficacement protégé lorsqu'il est au moins partiellement recouvert d'une couche de parylène.

Avantageusement, le substrat a une épaisseur inférieure à cent microns et/ou une face du substrat qui comprend une portion recouverte d'une couche de métallisation d'épaisseur inférieure à quinze microns.

D'autres caractéristiques et avantages de l'invention ressortiront de la description qui suit de modes de réalisation non limitatifs de l'invention.

### BREVE DESCRIPTION DES DESSINS

Il sera fait référence aux figures annexées parmi lesquelles :
- la figure 1 est une représentation schématique en coupe d'une première étape de réalisation d'un assemblage selon l'invention ;
- la figure 2 est une représentation schématique en coupe d'une deuxième étape de réalisation de l'assemblage de la figure 1;
- la figure 3 est une représentation schématique en coupe d'une troisième étape de réalisation de l'assemblage de la figure 1 ;
- la figure 4 est une représentation schématique en coupe d'une quatrième étape de réalisation de l'assemblage de la figure 1 ;
- la figure 5 est une représentation schématique en coupe d'un dispositif de mesure de pression selon un premier mode de réalisation de l'invention ;
- la figure 6 est une représentation schématique en coupe d'un dispositif de mesure de pression selon un deuxième mode de réalisation de l'invention ;
- la figure 7 est une représentation schématique en coupe d'un dispositif de mesure de pression selon un troisième mode de réalisation de l'invention ;
- la figure 8 est une représentation schématique en coupe d'un dispositif de mesure de pression selon un quatrième mode de réalisation de l'invention ;
- la figure 9 est une représentation schématique en coupe d'un dispositif de mesure de pression selon un cinquième mode de réalisation de l'invention.

### DESCRIPTION DETAILLEE DE L'INVENTION

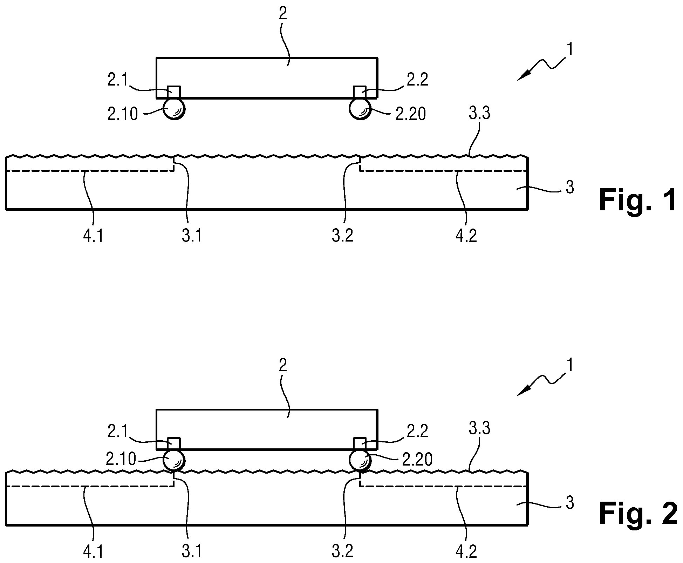

En référence à la figure 1, un assemblage électronique selon l'invention, et généralement désigné 1, est réalisé par brasage d'un composant 2 électronique sur un premier substrat 3. L'assemblage est destiné à fonctionner à une température de service maximale de l'ordre de deux cents degrés centigrades.

Ici, le composant 2 choisi est un microsystème électromécanique piezorésistif de mesure de pression en matériau non organique comme de la céramique Al203 Un tel composant 2 possède un coefficient de dilatation thermique sensiblement égal à de 7.10⁻⁶ K⁻¹ et une température de fusion supérieure à 2000 degrés Celsius Le composant 2 est pourvu d'un premier connecteur électrique 2.1 revêtu d'une première bille 2.10 de brasure à l'étain et un deuxième connecteur électrique 2.2 revêtu d'une deuxième bille 2.20 de brasure à l'étain.

Ici, le premier substrat 3 choisi est un substrat flexible texturé en silicium de quatre-vingt microns d'épaisseur. Le premier substrat 3 possède un coefficient de dilatation thermique sensiblement égal à 4.10⁻⁶ K⁻¹ et une température de fusion égale à 1414 degrés Celsius.

Au sens de la présente demande, un substrat est dit flexible s'il peut être courbé élastiquement à plus de quarante-cinq degrés.

Le premier substrat 3 est pourvu d'un troisième connecteur 3.1 électrique et un quatrième connecteur 3.2 électrique respectivement reliés à une première piste 4.1 conductrice et à une deuxième piste 4.2 conductrice obtenues par une métallisation sélective de la première face 3.3 du premier substrat 3 sur une épaisseur de dix microns.

Le composant 2 est placé sur le premier substrat 3 de manière à ce que le premier connecteur 2.1 et le deuxième connecteur 2.2 du composant 2 fassent respectivement face au troisième connecteur 3.1 et au quatrième connecteur 3.2 (figure 2). La première bille 2.10 repose sensiblement sur le troisième connecteur 3.1 et la deuxième bille 2.20 repose sensiblement sur le quatrième connecteur 3.2. Cette technique d'assemblage est aussi appelée « assemblage en puce retournée » ou « flip chip ».

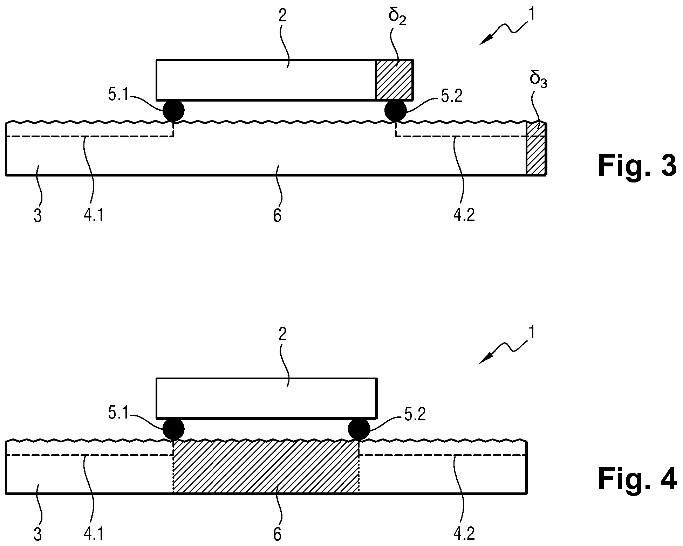

L'assemblage 1 est ensuit chauffé (ici par induction) et le premier connecteur 2.1 et le troisième connecteur 3.1 sont alors assemblés à l'aide d'une première brasure 5.1 à l'étain. Le deuxième connecteur 2.2 et le quatrième connecteur 3.1 sont assemblés à l'aide d'une deuxième brasure 5.2 à l'étain (figure 3).

Au cours des opérations de brasage et sous l'effet de la chaleur apportée (aux environs de 180 degrés centigrades), le premier substrat 3, dont le matériau possède un coefficient de dilatation thermique inférieur à celui du matériau du composant 2, va se dilater, tout comme le composant 2. Ainsi, la valeur ∂3 de la dilatation thermique du premier substrat 3 est inférieure à la valeur ∂2 de la dilatation thermique du matériau du composant 2. Le brasage du premier connecteur 2.1 sur le troisième connecteur 3.1 ainsi que le brasage du deuxième connecteur 2.2 sur le quatrième connecteur 3.1 se fait lorsque le composant 2 et le premier substrat 3 sont dilatés.

Lors du refroidissement de l'assemblage 1, la rétraction plus importante du composant 2 vis-à-vis du premier substrat 3 crée une mise en précontrainte de la première portion 6 de premier substrat 3 comprise entre la première brasure 5.1 et la deuxième brasure 5.2 (figure 4).

Les contraintes après assemblage dans la première brasure 5.1 et la deuxième brasure 5.2 sont sensiblement inférieures à 0.1N /MM².

Une couche de parylène de cinq microns est ensuite déposée sur l'assemblage 1 ainsi obtenu.

En fonctionnement, lorsque l'assemblage 1 est soumis à des variations de températures, l'amplitude du cycle des contraintes thermomécaniques subi par la première brasure 5.1 et la deuxième brasure 5.2 est réduit de la valeur de la précontrainte de la portion 6. La tenue en fatigue de la première brasure 5.1 et la deuxième brasure 5.2 est donc améliorée.

On obtient alors un assemblage 1 dont le premier substrat 3 possède un coefficient de dilatation thermique inférieur à celui du composant 2 qui y est relié.

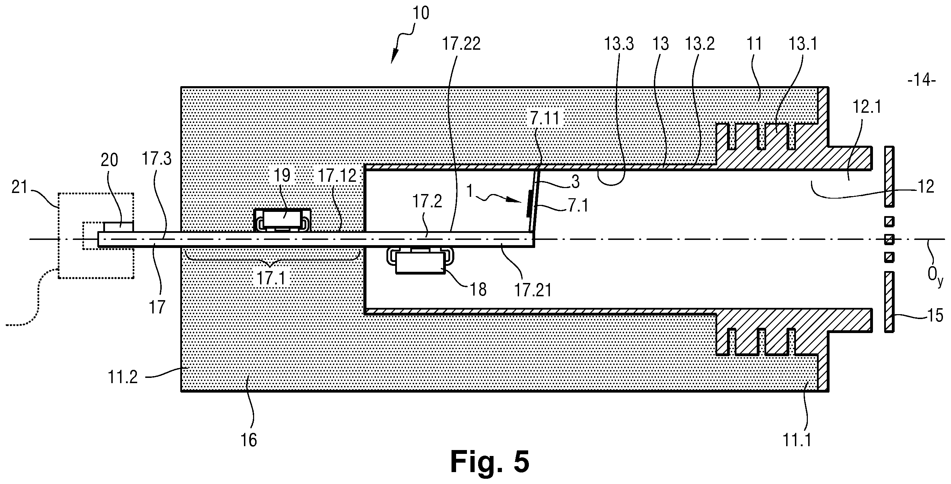

En référence à la figure 5, l'assemblage 1 est intégré à un dispositif 10 de mesure de pression.

Le dispositif 10 comprend un corps 11 en polyamide en forme de cylindre droit d'axe longitudinal Oy. Le corps 11 délimite une cavité 12 définie par une chemise 13 en acier inoxydable. La chemise 13 est ici en forme de cylindre droit d'axe longitudinal Oy et possède une série 13.1 de crampons en saillie radiale de la surface extérieure 13.2 de la chemise 13. Une première extrémité 12.1 de la cavité 12 débouche en une première extrémité 11.1 du corps 11 vers l'extérieur de la cavité 12 pour être en lien fluidique avec un fluide extérieur 14 dont la pression est à mesurer. Une grille 15 s'étend devant la première extrémité 12.1 de la cavité 12. La deuxième extrémité 11.2 du corps 11 est fermée par une paroi 16 transversale. La paroi 16 est traversée par une première portion intermédiaire 17.1 d'un circuit imprimé 17 en résine époxy dont une deuxième portion 17.2 s'étend dans la cavité 12 et une troisième portion 17.3 vient en saillie de l'extérieur du corps 11.

Le circuit imprimé 17 comprend un microprocesseur 18 porté par une face inférieure 17.21 de la deuxième portion 17.2 du circuit imprimé 17 ainsi qu'un module 19 de communication porté par la face supérieure 17.12 de la première portion 17.1 du circuit imprimé 17. Comme visible en figure 5, le module de communication 19 est, ici, noyé dans le corps 11. L'assemblage 1 est, ici, relié à la face supérieure 17.22 de la deuxième portion 17.2 du circuit imprimé 17 et une première portion 7.1 du premier substrat 3 s'étend depuis la deuxième portion 17.2 du circuit imprimé 17 jusqu'au conduit 13 de manière à ce qu'une première extrémité 7.11 de la portion 7.1 du premier substrat 3 vienne en contact avec la surface intérieure 13.3 de la chemise 13. Selon sa longueur et ou son inclinaison vis-à-vis de l'axe longitudinal Oy, la première extrémité 7.11 de la portion 7.1 du premier substrat 3 exerce un effort élastique plus ou moins important sur la chemise 12.

Des pistes conductrices non représentées portées par le circuit imprimé 17 relient l'assemblage 1, le microprocesseur 18 et l'unité de communication 19 à un premier port de sortie 20. Un connecteur 21 représentée en pointillés permet de relier le dispositif 10 à une unité de traitement non représentée.

La souplesse du premier substrat 3 et son montage particulier permet d'améliorer les performances du dispositif 10 en ce qui concerne la résistance aux vibrations et aux efforts thermomécaniques.

Les éléments identiques ou analogues à ceux précédemment décrits porteront une référence numérique identique à ceux-ci dans la description qui suit des deuxième, troisième, quatrième et cinquième modes de réalisation.

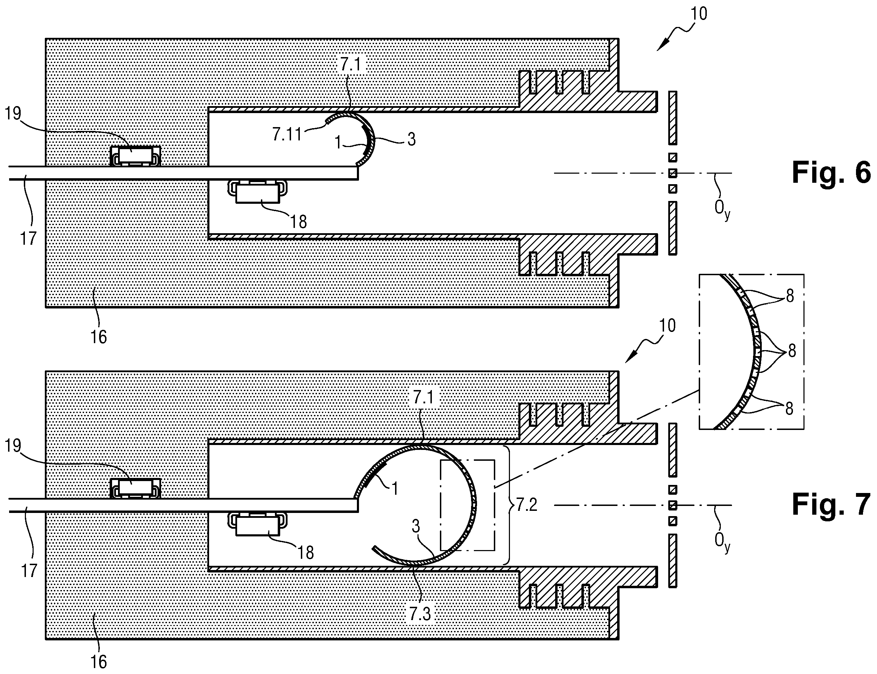

En référence à la figure 6, et selon un deuxième mode de réalisation de l'invention, la première portion 7.1 du premier substrat 3 qui est en contact avec la chemise 12 est courbée et exerce un effort élastique.

En référence à la figure 7, et selon un troisième mode de réalisation de l'invention, le premier substrat 3 comprend une première portion 7.1 courbée et qui est en contact avec la surface intérieure 13.3 de la chemise 13 ainsi qu'une deuxième portion 7.2 s'étendant sensiblement transversalement dans la cavité 12. Le premier substrat 3 comprend également une troisième portion 7.3 courbée qui est en contact avec la surface intérieure 13.3 de la chemise 13. Avantageusement, la deuxième portion 7.2 comprend dix orifices 8 qui sont destinés à laisser passer le fluide 14.

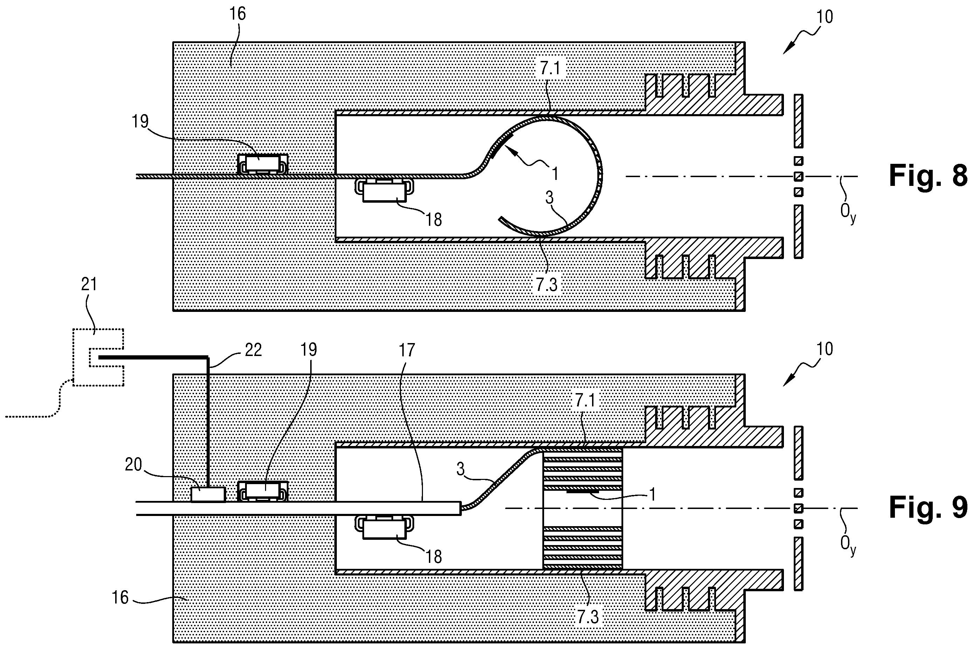

En référence à la figure 8, et selon un quatrième mode de réalisation de l'invention, le dispositif 10 est dépourvu de deuxième substrat 17 et le premier substrat 3 s'étend au travers de la paroi 16. Le premier substrat 3 porte alors l'assemblage 1ainsi que le microprocesseur 18, le module 19 et le port de sortie 20.

En référence à la figure 9, et selon un cinquième mode de réalisation de l'invention, le premier substrat 3 est conformé pour réaliser une spirale d'axe longitudinal Oy. Le premier substrat 3 est relié au deuxième substrat 17 et le port de communication 20 est, selon ce cinquième mode de réalisation, noyé dans le corps 11. Une broche 22 s'étend depuis le port de communication 20 au travers du corps 11 pour venir en saillie du corps 11 et accueillir en son extrémité le connecteur 21. La forme en spirale du premier substrat 3 permet à la première portion 7.1 du premier substrat 3 et à la troisième portion 7.3 du premier substrat 3, qui sont diamétralement opposées, d'exercer un effort élastique sur la chemise 13 à la façon d'un ressort en spirale.

Bien entendu, l'invention n'est pas limitée aux modes de réalisation décrits mais englobe toute variante entrant dans le champ de l'invention telle que définie par les revendications.

En particulier,
- bien que l'assemblage électronique soit obtenu à l'aide d'un procédé comprenant une sélection particulière du couple premier substrat/composant et un assemblage par apport de chaleur, le dispositif 10 peut intégrer un assemblage électronique obtenu à l'aide d'un autre procédé que celui de l'invention comme par exemple un assemblage d'un composant sur un substrat flexible obtenu par collage, ou encore un assemblage d'un composant sur un substrat dans lequel le substrat possède un coefficient de dilatation thermique supérieur à celui du composant électronique ;
- bien qu'ici la température de service maximale de l'assemblage soit de l'ordre de deux cents degrés centigrades, l'invention s'applique également à d'autres valeurs de température maximale de service comme par exemple des températures de service comprises entre zéro et deux cents degrés centigrades, des températures négatives ou supérieures à deux cents degrés centigrades ;
- bien qu'ici le composant soit un microsystème électromécanique piezorésistif de mesure de pression, l'invention s'applique également à d'autres types de composants comme par exemple des microsystèmes ou des nanosystèmes électromécaniques pouvant être capacitifs ou inductifs et ayant pour fonction de mesurer une pression, une température, ou d'assurer une fonction logique, de calcul ou de communication ;
- bien qu'ici le composant comprenne deux connecteurs, l'invention s'applique également à d'autres type de composant comme par exemple des composants comprenant un unique connecteur ou plus de deux ;
- bien qu'ici le substrat ait une épaisseur de quatre-vingt microns, l'invention s'applique également à d'autres types de substrat comme par exemple un substrat dont l'épaisseur est comprise entre un et quatre-vingt microns, ou d'une épaisseur supérieure à quatre-vingt microns, préférentiellement inférieure à cent microns ;
- bien qu'ici, les pistes conductrices soient obtenues par métallisation sélective d'une première face du premier substrat sur une épaisseur de dix microns, l'invention s'applique également à d'autres moyens de raccordement électrique pouvant comprendre par exemple des fils conducteurs et/ou des pistes conductrices internes et/ou des pistes conductrices imprimées ou obtenues par insolation sélective du substrat, l'épaisseur des pistes pouvant être inférieure à dix microns ou supérieures à onze microns, idéalement inférieure à quinze microns et les pistes pouvant s'étendre sur les deux faces du substrat;
- bien qu'ici, l'unité de traitement soit un microprocesseur, l'invention s'applique également à d'autres moyens de traitement comme par exemple un microcontrôleur, un FPGA ou une unité intégrée de type ASIC (de l'anglais « Application Specific Integrated Unité ») ;
- bien qu'ici l'assemblage soit recouvert d'une couche de parylène de cinq microns, l'invention s'applique également à d'autres types de couches de protection comme par exemple une couche de parylène inférieure à cinq microns ou supérieure à six microns, préférentiellement inférieure à dix microns, une couche de silicone, d'acrylique ou de polyuréthane ;
- bien qu'ici le dispositif comprenne une chemise en acier inoxydable qui définit une cavité du dispositif, l'invention s'applique également à d'autres moyens de définir une cavité comme par exemple une chemise définissant partiellement avec le corps la cavité ou une cavité intégralement définie par le corps du dispositif et dépourvue de chemise ;
- bien qu'ici la chemise soit en acier inoxydable, l'invention s'applique également à des chemises en d'autres matériaux comme par exemple une chemise en métal non ferreux tel que le cuivre ou le bronze, ou une chemise en matière synthétique (polyamide par exemple) ou en fibre de verre ou de carbone ;
- bien qu'ici le corps du dispositif soit en polyamide, l'invention s'applique également à d'autres types de matériaux thermoplastiques comme par exemple le polyéthylène basse ou haute densité et le PVC, ou des matériaux thermodurcissables comme le formaldéhyde ou le polyester ;
- bien qu'ici la cavité du dispositif soit en forme de cylindre droit, l'invention s'applique également à d'autres types de cavité comme par exemple des cavités de forme sphérique, conique ou quelconque ;
- bien qu'ici le deuxième substrat soit en résine époxy, l'invention s'applique également à d'autres types de deuxième substrat comme par exemple un substrat flexible en polymères à cristaux liquides ou un substrat rigide en polyimide ;
- bien qu'ici le module de communication soit porté par la face supérieure du deuxième substrat tout en étant noyé dans le corps du dispositif, l'invention s'applique également à d'autres implantation du module de communication comme par exemple un module de communication porté par une face inférieure du deuxième substrat, un module de communication s'étendant totalement ou partiellement dans la cavité, un module partiellement noyé dans le corps, un module de communication situé à l'extérieur du corps ;
- bien qu'ici les mesures de pression soient transmises à un circuit de communication extérieur via un connecteur filaire, l'invention s'applique également à d'autres moyens de communication comme par exemple des moyens de communication sans fil de type Bluetooth, Wi-Fi ou radio ;
- bien qu'ici le composant soit un composant simple, l'invention s'applique également à un composant comprenant un empilement de puces, dit « stack chip » ;
- bien qu'ici le premier substrat comprenne dix orifices pour laisser passer le fluide dont la pression est à mesurer, l'invention s'applique également à un premier substrat comprenant un nombre différent d'orifices comme par exemple entre un et neuf orifices ou plus de dix ;
- bien **qu'ici** les composants et le substrat aient été sélectionnés en regard de leurs températures de fusion, il sera idéalement fait usage de la température de transition vitreuse lorsque les matériaux sont des matériaux inorganiques.

## Revendications

1. Dispositif (10) comprenant un assemblage électronique (1) comportant un composant électronique (2) assemblé sur un premier substrat (3), et un corps (11) définissant une cavité (12), le composant électronique s'étendant dans la cavité (12),
dans lequel le coefficient de dilatation thermique du matériau du premier substrat (3) est inférieur à celui du composant électronique (2),
**caractérisé en ce que**
une première extrémité (12.1) de la cavité (12) est en lien fluidique avec un fluide (14),
le premier substrat (3) comprend une portion (7.1, 7.3) touchant une paroi de la cavité (12), et
le composant électronique (2) est assemblé par une méthode d'assemblage avec apport de chaleur de type brasage sur le premier substrat (3).

2. Dispositif (10) selon la revendication 1, dans lequel le composant électronique (2) est un capteur de pression.

3. Dispositif (10) selon la revendication 1 ou 2, dans lequel le premier substrat (3) est un substrat flexible.

4. Dispositif (10) selon l'une quelconque des revendications précédentes, dans lequel la portion (7.1, 7.3) touchant la paroi de la cavité (12) est une portion courbée.

5. Dispositif (10) selon l'une quelconque des revendications précédentes, dans lequel le premier substrat (3) exerce un effort élastique sur la paroi de la cavité (12).

6. Dispositif (10) selon l'une quelconque des revendications précédentes, dans lequel le premier substrat (3) comprend des orifices (8) destinés à laisser passer une fraction du fluide (14).

7. Dispositif (10) selon l'une quelconque des revendications précédentes, dans lequel le premier substrat (3) est relié à un deuxième substrat (17) qui porte une unité de communication (19) et un port de communication (20).

8. Dispositif (10) selon l'une quelconque des revendications précédentes, dans lequel le deuxième substrat (17) est un substrat rigide ou un substrat flexible.

9. Dispositif (10) selon l'une quelconque des revendications 7 ou 8, dans lequel le deuxième substrat (17) s'étend en partie dans la cavité (12).

10. Dispositif (10) selon l'une quelconque des revendications précédentes, comprenant une grille (15) s'étendant devant la première extrémité (12.1) de la cavité (12).

11. Dispositif (10) selon l'une quelconque des revendications précédentes, dans lequel la cavité est définie au moins partiellement par une chemise (12) en métal.

12. Dispositif (10) selon la revendication 11, dans lequel la chemise (12) est en acier inoxydable.

13. Dispositif (10) selon l'une quelconque des revendications précédentes, dans lequel le corps (11) est en matériau thermoplastique.

14. Dispositif (10) selon la revendication 1, dans lequel le premier substrat (3) est un substrat texturé.

15. Dispositif (10) selon la revendication 1 ou 14, dans lequel le premier substrat (3) est un substrat à base de polymères à cristaux liquides.

16. Dispositif (10) selon l'une des revendications 1, 14 et 15, comprenant au moins un composant assemblé en puce retournée.

17. Dispositif (10) selon l'une des revendications 1 et 14 à 16, comprenant au moins un composant comportant un empilement de puces.

18. Dispositif (10) selon l'une des revendications 1 et 14 à 17, dans lequel l'assemblage électronique (1) est au moins partiellement recouvert d'une couche de parylène.

19. Dispositif (10) selon l'une des revendications 1 et 14 à 18, dans lequel le premier substrat (3) a une épaisseur inférieure à cent microns.

20. Dispositif (10) selon l'une des revendications 1 et 14 à 19, dans lequel au moins une face du premier substrat (3) comprend une portion recouverte d'une couche de métallisation d'épaisseur inférieure à quinze microns.

21. Procédé de réalisation d'un assemblage électronique (1) d'un dispositif selon l'une quelconque des revendications précédentes, comprenant les étapes suivantes :
lors d'une phase préparatoire,
- sélectionner un composant électronique (2) ;
- sélectionner un premier substrat (3) sur lequel doit être assemblé le composant électronique (2) de manière à ce que le coefficient de dilatation thermique du matériau du premier substrat (3) soit inférieur à celui du composant électronique (2);
le procédé étant **caractérisé en ce que**, lors d'une phase d'assemblage, le procédé comprend une étape d'assembler par une méthode d'assemblage avec apport de chaleur de type brasage le composant électronique (2) et le premier substrat (3).

22. Procédé selon la revendication 21, dans lequel la phase préparatoire comprend l'étape supplémentaire de sélectionner un composant électronique (2) et un premier substrat (3) dont les matériaux ont tous deux une température de transition vitreuse et/ou une température de fusion supérieure à une température de service de l'assemblage électronique (1).

23. Procédé selon l'une des revendications 21 ou 22, dans lequel la phase préparatoire comprend l'étape supplémentaire de sélectionner un composant électronique (2) et un premier substrat (3) ainsi qu'une technique d'assemblage qui aboutissent à une contrainte après assemblage dans les points de jonction (5.1 ; 5.2) entre le composant électronique (2) et le premier substrat (3) et inférieur à 0,1N/mm² .

## Patentansprüche

1. Vorrichtung (10), umfassend eine elektronische Baugruppe (1) mit einer elektronischen Komponente (2), die auf einem ersten Substrat (3) montiert ist, sowie einen Körper (11), der einen Hohlraum (12) definiert, wobei sich die elektronische Komponente in den Hohlraum (12) hinein erstreckt,
wobei der thermische Ausdehnungskoeffizient des Materials des ersten Substrats (3) geringer ist als jener der elektronischen Komponente (2),
**dadurch gekennzeichnet, dass**
ein erstes Ende (12.1) des Hohlraums (12) in Fluidverbindung mit einem Fluid (14) steht,
das erste Substrat (3) einen Abschnitt (7.1, 7.3) umfasst, der mit einer Wand des Hohlraums (12) in Kontakt steht, und
die elektronische Komponente (2) unter Verwendung eines thermischen Fügeverfahren vom Typ Löten auf dem ersten Substrat (3) montiert ist.

2. Vorrichtung (10) nach Anspruch 1, wobei es sich bei der elektronischen Komponente (2) um einen Drucksensor handelt.

3. Vorrichtung (10) nach Anspruch 1 oder 2, wobei es sich bei dem ersten Substrat (3) um ein flexibles Substrat handelt.

4. Vorrichtung (10) nach einem der vorhergehenden Ansprüche, wobei es sich bei dem mit der Wand des Hohlraums (12) in Kontakt stehenden Abschnitt (7.1, 7.3) um einen gekrümmten Abschnitt handelt.

5. Vorrichtung (10) nach einem der vorhergehenden Ansprüche, wobei das erste Substrat (3) eine elastische Kraft auf die Wand des Hohlraums (12) ausübt.

6. Vorrichtung (10) nach einem der vorhergehenden Ansprüche, wobei das erste Substrat (3) Öffnungen (8) umfasst, durch welche ein Bruchteil des Fluids (14) hindurchfließen kann.

7. Vorrichtung (10) nach einem der vorhergehenden Ansprüche, wobei das erste Substrat (3) mit einem zweiten Substrat (17) verbunden ist, das eine Kommunikationseinheit (19) und einen Kommunikationsanschluss (20) trägt.

8. Vorrichtung (10) nach einem der vorhergehenden Ansprüche, wobei es sich bei dem zweiten Substrat (17) um ein starres Substrat oder um ein flexibles Substrat handelt.

9. Vorrichtung (10) nach einem der Ansprüche 7 oder 8, wobei sich das zweite Substrat (17) teilweise in den Hohlraum (12) hinein erstreckt.

10. Vorrichtung (10) nach einem der vorhergehenden Ansprüche, umfassend ein Gate (15), das sich vor dem ersten Ende (12.1) des Hohlraums (12) erstreckt.

11. Vorrichtung (10) nach einem der vorhergehenden Ansprüche, wobei der Hohlraum zumindest teilweise durch eine Hülse (12) aus Metall definiert ist.

12. Vorrichtung (10) nach Anspruch 11, wobei die Hülse (12) aus Edelstahl besteht.

13. Vorrichtung (10) nach einem der vorhergehenden Ansprüche, wobei der Körper (11) aus einem thermoplastischen Material besteht.

14. Vorrichtung (10) nach Anspruch 1, wobei es sich bei dem ersten Substrat (3) um ein texturiertes Substrat handelt.

15. Vorrichtung (10) nach Anspruch 1 oder 14, wobei es sich bei dem ersten Substrat (3) um ein Substrat auf Basis von Flüssigkristallpolymeren handelt.

16. Vorrichtung (10) nach einem der Ansprüche 1, 14 und 15, umfassend zumindest eine in Flip-Chip-Technik montierte Komponente.

17. Vorrichtung (10) nach einem der Ansprüche 1 und 14 bis 16, umfassend zumindest eine Komponente mit einer Chipstapelung.

18. Vorrichtung (10) nach einem der Ansprüche 1 und 14 bis 17, wobei die elektronische Baugruppe (1) zumindest teilweise mit einer Parylenschicht überzogen ist.

19. Vorrichtung (10) nach einem der Ansprüche 1 und 14 bis 18, wobei das erste Substrat (3) eine Dicke von weniger als hundert Mikron aufweist.

20. Vorrichtung (10) nach einem der Ansprüche 1 und 14 bis 19, wobei zumindest eine Seite des ersten Substrats (3) einen Abschnitt umfasst, der mit einer Metallisierungsschicht überzogen ist, die eine Dicke von weniger als fünfzehn Mikron aufweist.

21. Verfahren zur Herstellung einer elektronischen Baugruppe (1) einer Vorrichtung nach einem der vorhergehenden Ansprüche, umfassend die Schritte, dass:
während einer Vorbereitungsphase
- eine elektronische Komponente (2) ausgewählt wird;
- ein erstes Substrat (3) ausgewählt wird, auf welchem die elektronische Komponente (2) derart montiert wird, dass der thermische Ausdehnungskoeffizient des Materials des ersten Substrats (3) geringer ist als jener der elektronischen Komponente (2);
wobei das Verfahren **dadurch gekennzeichnet ist, dass** während einer Fügephase das Verfahren einen Schritt umfasst, in welchem die elektronische Komponente (2) und das erste Substrat (3) unter Verwendung eines thermischen Fügeverfahrens vom Typ Löten miteinander verbunden werden.

22. Verfahren nach Anspruch 21, wobei die Vorbereitungsphase den zusätzlichen Schritt umfasst, dass eine elektronische Komponente (2) und ein erstes Substrat (3) ausgewählt werden, welche beide eine Glasübergangstemperatur und/oder eine Schmelztemperatur aufweisen, die höher ist als eine Betriebstemperatur der elektronischen Baugruppe (1).

23. Verfahren nach einem der Ansprüche 21 oder 22, wobei die Vorbereitungsphase den zusätzlichen Schritt umfasst, dass eine elektronische Komponente (2) und ein erstes Substrat (3) sowie eine Fügetechnik derart ausgewählt werden, dass nach dem Fügevorgang die Spannung an den Verbindungsstellen (5.1 ; 5.2) zwischen der elektronischen Komponente (2) und dem erstem Substrat (3) weniger als 0,1N/mm2 beträgt.

## Claims

1. A device (10) having both an electronic assembly (1) comprising an electronic component (2) assembled on a first substrate (3), and also a body (11) defining a cavity (12), the electronic component (2) extending in the cavity,
wherein the coefficient of thermal expansion of the material of the first substrate (3) is less than that of the electronic component (2),
**characterized in that**
a first end (12.1) of the cavity is in fluid flow communication with a fluid (14),
the first substrate (3) includes a portion (7.1, 7.3) in contact with a wall of the cavity (12),
and the electronic component (2) is assembled on the first substrate (3) by a brazing type assembly method involving the application of heat.

2. A device (10) according to claim 1, wherein the electronic component (2) is a pressure sensor.

3. A device (10) according to claim 1 or claim 2, wherein the first substrate (3) is a flexible substrate.

4. A device (10) according to any preceding claim, wherein the portion (7.1, 7.3) in contact with a wall of the cavity (12) is a curved portion.

5. A device (10) according to any preceding claim, wherein the first substrate (3) exerts a resilient force on the wall of the cavity (12).

6. A device (10) according to any preceding claim, wherein the first substrate (3) includes orifices (8) for passing a fraction of the fluid (14).

7. A device (10) according to any preceding claim, wherein the first substrate (3) is connected to a second substrate (17) that carries a communication unit (19) and a communication port (20).

8. A device (10) according to any preceding claim, wherein the second substrate (17) is a rigid substrate or a flexible substrate.

9. A device (10) according to claim 7 or claim 8, wherein the second substrate (17) extends in part into the cavity (12).

10. A device (10) according to any preceding claim, including a grid (15) extending in front of the first end (12.1) of the cavity (12).

11. A device (10) according to any preceding claim, wherein the cavity is defined, at least in part, by a metal liner (12).

12. A device (10) according to claim 11, wherein the liner (12) is made of stainless steel.

13. A device (10) according to any preceding claim, wherein the body (11) is made of thermoplastic material.

14. A device (10) according to claim 1, wherein the first substrate (3) is a textured substrate.

15. A device (10) according to claim 1 or 14, wherein the first substrate (3) is a substrate based on liquid crystal polymers.

16. A device (10) according to any one of claims 1, 14 and 15, including at least one flip chip assembled component.

17. A device (10) according to any one of claims 1 and 14 to 16, including at least one component comprising a stack chip.

18. A device (10) according to any one of claims 1 and 14 to 17, wherein the electronic assembly (1) is covered, at least in part, by a layer of Parylene.

19. A device (10) according to any one of claims 1 and 14 to 18, wherein the first substrate (3) has a thickness that is less than 100 µm.

20. A device (10) according to any one of claims 1 and 14 to 19, wherein at least one face of the first substrate (3) includes a portion covered in a layer of metallization of thickness less than 15 µm.

21. A method of making an electronic assembly (1) of a device (10) according to any preceding claim, the method comprising the following steps:
during a preparatory stage:
· selecting an electronic component (2); and
· selecting a first substrate (3) on which the electronic component (2) is to be assembled, the first substrate (3) being selected in such a manner that the coefficient of thermal expansion of the material of the first substrate (3) is less than that of the electronic component (2); and
the method being **characterized in that**, during an assembly stage, the method comprises the step of assembling together the electronic component (2) and the first substrate (3) by a brazing type assembly method involving the application of heat.

22. A method according to claim 21, wherein the preparatory stage includes the additional step of selecting an electronic component (2) and a first substrate (3), both made of materials having a glass transition temperature and/or a melting temperature that is higher than a service temperature of the electronic assembly (1).

23. A method of making an electronic assembly (1) according to claim 21 or claim 22, wherein the preparatory stage includes the additional step of selecting an electronic component (2) and a first substrate (3) and also an assembly technique that leads, after assembly, to stress of less than 0.1 N/mm² in the junction points (5.1; 5.2) between the electronic component (2) and the first substrate (3).
